Europäisches Patentamt

European Patent Office

Office européen des brevets

(19)

(11) Veröffentlichungsnummer: **0 207 226**
**B1**

(12) **EUROPÄISCHE PATENTSCHRIFT**

(45) Veröffentlichungstag der Patentschrift:
**27.12.89**

(51) Int. Cl.⁴: **H05K 9/00**

(21) Anmeldenummer: **86103838.8**

(22) Anmeldetag: **20.03.86**

(54) **Hochfrequenzdichtes Gehäuse.**

(30) Priorität: **03.07.85 DE 3523770**

(43) Veröffentlichungstag der Anmeldung:
**07.01.87 Patentblatt 87/2**

(45) Bekanntmachung des Hinweises auf die Patenterteilung:
**27.12.89 Patentblatt 89/52**

(84) Benannte Vertragsstaaten:
**AT CH DE LI NL**

(56) Entgegenhaltungen:
**DE-A- 2 750 088**
**DE-B- 2 448 421**
**DE-B- 2 451 192**
**DE-U- 7 525 506**
**US-A- 4 381 421**

(73) Patentinhaber: **ROBERT BOSCH GMBH, Postfach 50,
D-7000 Stuttgart 1(DE)**

(72) Erfinder: **Meissner, Udo, Seehofstrasse 73,
D-1000 Berlin 37(DE)**
Erfinder: **Misera, Herbert A., Strasse 263 Nr. 15,
D-1000 Berlin 47(DE)**

(74) Vertreter: **Schmidt, Hans-Ekhardt, Robert Bosch GmbH
Geschäftsbereich Elektronik Patent- und
Lizenzabteilung Forckenbeckstrasse 9-13,
D-1000 Berlin 33(DE)**

## Beschreibung

### Stand der Technik

Die Erfindung geht von einem hochfrequenzdichten Gehäuse nach der Gattung des Patentanspruchs 1 aus.

Es ist schon ein hochfrequenzdichtes Gehäuse bekannt (DE-Gbm 75 25 506), bei dem ein Gehäuseunterteil mit einem umlaufenden Flansch durch einen Deckel mit den Flansch umgreifendem Rand abgeschlossen ist, Der Deckel trägt auf seiner ebenen Innenseite Blechstreifen mit federnden Zungen, die bei auf das Gehäuseunterteil aufgesetztem Deckel auf dem Flansch liegen. Der Kontakt zwischen den federnden Zungen und dem Flansch des Gehäuseunterteils entsteht erst, wenn der Deckel mittels Schrauben an dem Unterteil befestigt wird. Weist der Deckel eine geringe Dicke, das heißt keine ausreichende Steifigkeit auf, so müssen die Schrauben in kurzen Abständen gesetzt werden, damit ein gleichmäßiger Kontaktdruck entsteht.

### Vorteile der Erfindung

Das hochfrequenzdichte Gehäuse mit den kennzeichnenden Merkmalen des Patentanspruchs 1 hat den Vorteil, daß die Kontaktgabe zwischen Deckel bzw. zwischen den federnden Zungen von Federblechstreifen und einer Gehäusewand nicht an das Vorhandensein von Schraubverbindungen zwischen Deckel und Gehäuse gebunden ist und daß keine Befestigungselemente für das Anbringen des Blechstreifens an dem Deckel erforderlich sind. Bei dem hochfrequenzdichten Gehäuse gemäß dem DE-Gbm 75 25 506 sind zu diesem Zweck kegelstiftförmige Ansätze am Deckel vorgesehen. Bei dem erfindungsgemäßen Gehäuse genügt ein einfaches Aufstecken der Federblechstreifen auf den Deckelrand, um Widerhaken des Federblechstreifens zur Wirkung kommen zu lassen, die den Federblechstreifen an dem Deckelrand festhalten.

Durch die in dem Patentanspruch 2 aufgeführten Maßnahmen erreicht man den Vorteil, daß mit dem Aufstecken des Deckels auf das Gehäuseunterteil die Widerhaken stärker in die Oberfläche der Innenseite des Deckelrandes gepreßt werden, so daß eine schwer lösbare Verbindung zwischen Federblechstreifen und Deckelrand entsteht.

### Zeichnung

Ein Ausführungsbeispiel der Erfindung ist in der Zeichnung an Hand mehrerer Figuren dargestellt und in der nachfolgenden Beschreibung näher erläutert. Die Zeichnung zeigt in

Fig. 1 eine Seitenansicht eines erfindungsgemäßen Federblechstreifens,

Fig. 2 eine Schnittansicht des Federblechstreifens gemäß dem Schnittverlauf II-II in Fig. 1 und

Fig. 3 eine Schnittansicht eines erfindungsgemäßen Gehäuses mit dem erfindungsgemäßen Federblechstreifen.

### Beschreibung der Erfindung

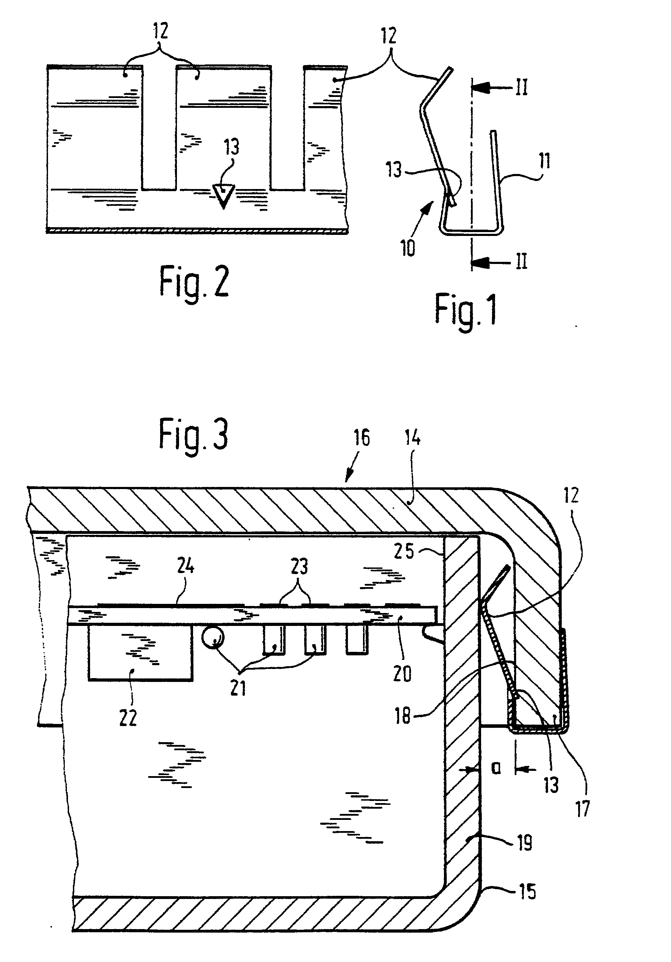

In den Fig. 1 und 2 bezeichnet 10 einen erfindungsgemäßen Federblechstreifen, der ein U-förmiges Teil 11 und in Verlängerung des einen Schenkels des U Zungen 12 aufweist. Die Zungen sind dach- bzw. bogenförmig. Zweckmäßigerweise enthalten die Zungen 12 je einen nach innen vorstehenden, zum Beispiel dreieckförmigen Widerhaken 13, der beispielsweise durch einen Schneidvorgang entstanden ist. Ein Deckel 14 bildet zusammen mit einem Gehäuseunterteil 15 und dem Federblechstreifen 10 ein hochfrequenzdichtes Gehäuse 16; Fig. 3. Die Federblechstreifen 10 werden mit ihrem U-förmigen Teil 11 auf einen Rand 17 des Deckels 14 gesteckt, wobei die Widerhaken 13 sich an der Innenseite 18 des Deckelrandes 17 festkrallen und den Federblechstreifen an dem Deckel festhalten und die Kontaktgabe zwischen Deckel und Federblechstreifen verbessern.

Der Deckelrand 17 hat einen Abstand a von der zugehörigen Gehäuseseitenwand 19 des Gehäuseunterteils 15, so daß die Federzungen 12 in dem Raum zwischen der Gehäuseseitenwand 19 und dem Deckelrand 17 Platz finden. Bei auf das Gehäuseunterteil 15 aufgestecktem Deckel 14 werden die Zungen 12 zusammengedrückt, wodurch sich die Widerhaken 13 etwas stärker in die Innenseite des Deckelrandes 17 eingraben und die bogen- oder dachförmigen Zungen mit der Gehäuseseitenwand 19 bzw. dem Gehäuseunterteil 15 Kontakt machen.

Im Gehäuseunterteil 15 ist beispielsweise eine Leiterplatte 20 vorgesehen, die auf der Innenseite elektrische Bauelemente 21 und Bauteile 22 und auf der Außenseite Leiterbahnen 23 und Leiterflächen 24 trägt.

In einer alternativen Ausführungsform des hochfrequenzdichten Gehäuses 16 nach Fig. 3 kann der U-förmige Teil 11 des Federblechstreifens 10 auf den Rand 25 der Gehäuseseitenwand 19 gesteckt sein, wobei die bogen- oder dachförmigen Zungen 12 an der Innenseite 18 des Deckelrandes 17 Kontakt machen und die Widerhaken 13 in der Außenseite der Gehäuseseitenwand 19 eingedrückt werden.

Der Federblechstreifen 10 besteht vorzugsweise aus mehreren Stücken, die auf dem Deckelrand 17 aneinandergereiht werden.

### Patentansprüche

1. Hochfrequenzdichtes Gehäuse aus einem Gehäuseunterteil, einem Deckel mit Rand und einem Federblechstreifen mit federnden Zungen, der mit dem Deckel verbunden ist und mit dem Gehäuseunterteil Kontakt macht, dadurch gekennzeichnet, daß der Rand (17) des Deckels (14) das Gehäuseunterteil (15) in einem bestimmten Abstand (a) umgibt, daß auf den Rand ein im Querschnitt U-förmiges Teil (11) des Federblechstreifens (10) gesteckt ist, dessen in den Raum zwischen dem Rand und dem Gehäuse hineinragende bogen- oder dachförmigen Zungen (12) sich mit ihrer vorgewölbten Seite an der Außenseite des Gehäuses (16) abstützen und aus dem Federblechstreifen hervorstehende Widerhaken (13) aufweisen, die sich am Rande des Deckels festkrallen.

2. Hochfrequenzdichtes Gehäuse nach Anspruch 1, dadurch gekennzeichnet, daß die Widerhaken (13) aus den Zungen (12) des Federblechstreifens (10) hervorstehen und sich an der Innenseite (18) des Randes (17) des Deckels (14) festkrallen.

3. Hochfrequenzdichtes Gehäuse nach Anspruch 1 oder 2, dadurch gekennzeichnet, daß die Widerhaken (13) dreieckförmig ausgebildet sind.

## Claims

1. High-frequency screened case comprising a case bottom section, a lid including edge, and a spring-leaf strip with resilient tongues which is connected with the lid and makes contact with the case bottom section, characterised in that the edge (17) of the lid (14) circumvents the case bottom section (15) at a certain distance (a); that a cross-sectionally U-shaped part (11) of the spring-leaf strip (10) is pushed onto the edge, with the curved or roof-shaped tongues (12) of the spring-leaf strip which enter into the space between the edge and the housing propping themselves up by their pre-curved side against the outside of the case (16) and having barbed hooks protruding from the spring-leaf strip which hooks claw into the edge of the lid.

2. High-frequency screened case according to claim 1, characterized in that the barbed hooks (13) protrude from the tongues (12) of the spring-leaf strip (10) and claw into the inside (18) of the edge (17) of the lid (14).

3. High-frequency screened case according to claim 1 or 2, characterised in that the barbed hooks (13) are triangularly shaped.

## Revendications

1. Boîtier étanche aux hautes fréquences très élevées, composé d'une partie inférieure de boîtier, d'un couvercle avec un bord et d'une bande de tôle élastique avec des languettes élastiques, bande reliée au couvercle et venant en contact avec la partie inférieure du boîtier, caractérisé en ce que le bord (17) du couvercle (14) entoure la partie inférieure (15) du boîtier à une certaine distance (a), une pièce (11) à section en forme de U de la bande de tôle élastique (10) étant emmanchée sur le bord, pièce (11) dont les languettes courbes (12) ou en forme de toits qui viennent en saillie dans l'intervalle entre le bord et le boîtier, s'appuient par leur partie bombée contre la face extérieure du boîtier (16) et comportent des crochets de retenue (13) qui viennent en saillie par rapport à la bande de tôle élastique, crochets qui s'accrochent au bord du couvercle.

2. Boîtier étanche aux hautes fréquences selon la revendication 1, caractérisé en ce que les crochets de retenue (13) sont en saillie par rapport aux languettes (12) de la bande de tôle élastique (10) et s'accrochent contre la face intérieure (18) du bord (17) du couvercle (14).

3. Boîtier étanche aux hautes fréquences selon la revendication 1 ou 2, caractérisé en ce que les crochets de retenue (13) ont une forme triangulaire.

Fig. 2

Fig. 1

Fig. 3